Europäisches Patentamt

(19) European Patent Office

Office européen des brevets

(11) Veröffentlichungsnummer: **0 054 310**

A2

(12) **EUROPÄISCHE PATENTANMELDUNG**

(21) Anmeldenummer: 81110516.2

(22) Anmeldetag: 16.12.81

(51) Int. Cl.³: **H 05 K 3/02**
**G 03 G 7/00**

(30) Priorität: 17.12.80 DE 3047498

(43) Veröffentlichungstag der Anmeldung:
23.06.82 Patentblatt 82/25

(84) Benannte Vertragsstaaten:
AT BE CH DE FR GB IT LI LU NL SE

(71) Anmelder: Karnikowski, Herbert
Im Wiesenkamp 7
D-4600 Dortmund 14(DE)

(72) Erfinder: Karnikowski, Herbert
Im Wiesenkamp 7
D-4600 Dortmund 14(DE)

(74) Vertreter: Schulze Horn, Hannes, Dr.-Ing.
Im Defdahl 51
D-4600 Dortmund 1(DE)

(54) Übertragungfolie für die Übertragung von Abbildungen auf Oberflächen, sowie Übertragungsverfahren und Vorrichtung.

(57) Die Erfindung betrifft eine Übertragungsfolie, vorzugsweise mit dem Grundmaterial Papier, für die Übertragung von Abbildungen auf Oberflächen, insbesondere auf die Cu-Deckschicht von Platinen oder auf andere ätzbare Oberflächen. Sie ist dadurch gekennzeichnet, daß sie eine, die Abbildung in spiegelverkehrter Form aufweisende, lösbare Überträgerschicht, insbesondere eine Metalloxydschicht einer adhäsiven Deckschicht auf der Oberfläche aufweist.

Zwischen der Überträgerschicht, z.B. der Metalloxydschicht und dem Grundmaterial der Folie ist eine vorzugsweise thermoplastische, Trennschicht angeordnet, wobei die Metalloxydschicht die ZnO-Schicht eines Kopierpapiers und die adhäsive Deckschicht der Toner auf dem kopierten Kopierpapier ist.

In Durchführung der Erfindung ist vorgesehen, daß zunächst auf einem Kopiergerät, insbesondere einem ZnO-Trockenkopierer, von einer spiegelverkehrten Vorlage eine spiegelverkehrte Kopie der zu übertragenden Abbildung hergestellt wird, die auf 80°C bis 140°C, insbesondere jedoch auf 100°C bis 120°C erwärmt und unter Druckanwendung auf die mit der Abbildung zu versehende Oberfläche aufgelegt wird. Die Übertragung der Abbildung erfolgt durch mittelbares Haften der Überträgerschicht über den Toner auf der mit der Abbildung zu versehenden Oberfläche.

./...

Beschreibung

Die Erfindung betrifft eine Übertragungsfolie, vorzugsweise mit dem Grundmaterial Papier, für die Übertragung von Abbildungen auf Oberflächen, insbesondere auf die Cu-Deckschicht von Platinen oder auf andere ätzbare Oberflächen sowie ein Übertragungsverfahren und eine Übertragungsvorrichtung.

Zur Herstellung von Leiterplatten mit herausgeätzten Leiterbahnen (Platinen) ist das fotografische Verfahren bekannt. Bei diesen wird von einem gezeichneten Schaltbild ein Negativ angefertigt und auf fotografischem Wege auf die zu ätzende Schicht übertragen. Da dieses Verfahren relativ kostenaufwendig ist, wird bei Leiterplatten, bei denen das Auflösungsvermögen nicht sehr groß sein muß, auch mit dem Siebdruckverfahren gearbeitet. Beiden Verfahren ist gemeinsam, daß sie zur Herstellung von Klein- und Kleinstserien aus Kostengründen nicht geeignet sind. Von dem Elektronikamateur, der seine Schaltbilder aus Elektronik-Fachzeitschriften entnimmt, können sie nicht angewendet werden. Auch abgewandelte Foto- und Siebdruckverfahren können bisher die Benutzer der in Fachzeitschriften veröffentlichten Schaltbilder nicht befriedigen.

Es ist Aufgabe der Erfindung, eine Übertragungsfolie, ein Folien-Herstellungsverfahren und eine Übertragungsvorrichtung anzugeben, die bei kleinen Serien und Einzelplatinen eine einfache, kostengünstige Herstellung bei guter Übertragungssicherheit aller Details erlauben. Weiterhin soll es auch möglich sein, beliebige Abbildungen, z.B. Kupferstiche, Stahlstiche etc., die z.B. in Kunstbänden veröffentlicht sind, leicht und einfach auf ätzbare Oberflächen zu übertragen.

0054310

Ear/60/1

Die Aufgabe wird dadurch gelöst, daß eine Übertragungsfolie geschaffen wird, die eine die Abbildung in spiegelverkehrter Form aufweisende lösbare Überträgerschicht, insbesondere eine Metalloxydschicht mit einer adhäsiven Deckschicht auf der Oberfläche aufweist. So kann vorteilhafterweise das gewünschte Schaltbild oder Bild auf die zu ätzende Oberfläche übertragen werden. Eine Metalloxydschicht mit adhäsiver Deckschicht ist überraschenderweise bereits ausreichend ätzresistent, so daß eine weitere Behandlung der Abbildungsoberfläche vor dem Ätzen entfällt. Durch die direkte Übertragung mit Hilfe einer Folie, von der sich eine Überträgerschicht, die das Bild enthält, ablöst, ist auch die Übertragungsgenauigkeit gewährleistet. Die Übertragungsfolie ist kostengünstig, da ihr Grundmaterial aus Papier besteht und die Überträgerschicht aus Metalloxyd mit ihrer adhäsiven Deckschicht sehr dünn, im 100stel mm Dickenbereich gehalten werden kann.

In weiterer Ausgestaltung der Erfindung ist vorgesehen, daß zwischen der Überträgerschicht, z.B. der Metalloxydschicht und dem Grundmaterial der Folie eine, vorzugsweise thermoplastische, Trennschicht angeordnet ist. Durch die Anordnung einer thermoplastischen Trennschicht zwischen Überträgerschicht und Grundmaterial ist gewährleistet, daß bei Erwärmung tatsächlich nur die Überträgerschicht auf der zu ätzenden Fläche haftet und das Grundmaterial ohne weiteres abgezogen werden kann.

In weiterer Ausgestaltung der Erfindung ist vorgesehen, daß das Metalloxyd elektrisch aufladbar und durch Lichteinwirkung entladbar, insbesondere ZnO ist. Durch ein elektrisch aufladbares und durch Lichteinwirkung entladbares Metalloxyd, insbesondere ZnO, ist es möglich, die erfindungsgemäßen spiegelverkehrten Abbildungen auf der Übertragungsfolie durch den bekannten xerographischen Trockenkopierprozeß zu erzeugen. Da Kopien von Trockenkopierern sehr preiswert sind, ergibt sich so ein bisher unerreicht kostengünstiges

Übertragungsverfahren für gedruckte Schaltungen etc. auf Platinen oder andere ätzbare Oberflächen.

In weiterer Ausgestaltung der Erfindung ist vorgesehen, daß die adhäsive Deckschicht thermoplastisch, vorzugsweise mit höherem Erweichungspunkt als die Trennschicht ist. Auf diese Art und Weise wird vorteilhaft erreicht, daß die Trennung des Grundmaterials (Papier) von der Überträgerschicht (Metalloxyd) bei Erwärmung fehlerfrei erfolgt. Ein Wiederablösen der Überträgerschicht von der zu ätzenden Oberfläche bei dem Abziehen der Papierschicht ist so ausgeschlossen.

In weiterer Ausgestaltung der Erfindung ist vorgesehen, daß die Metalloxydschicht die ZnO-Schicht eines Kopierpapiers und die adhäsive Deckschicht der Toner auf dem kopierten Kopierpapier ist. So kann in überraschender, vorteilhafter Weise ein unverändert bleibender, nach dem xerographischen Prinzip arbeitender Trockenkopierer, die Herstellung der Übertragungfolie übernehmen. Um eine spiegelverkehrte Abbildung herzustellen, ist dabei nur notwendig, das Schaltbild oder andere Bilder zunächst auf Transparentpapier oder eine durchsichtige Folie aufzubringen und von der Rückseite her aufzunehmen. Es können aber auch in Fachzeitschriften veröffentlichte, bereits spiegelverkehrt abgebildete Schaltbilder verwendet werden. Die Herstellung der Überträgerfolie mit Hilfe eines Trockenkopierers ist so völlig problemlos und erfolgt in bisher unerreichter Weise schnell und kostengünstig.

Zur Herstellung von Platinen mit gedruckten Schaltungen oder anderen Ätzbildern unter Verwendung der erfindungsgemäßen Übertragungsfolie ist vorgesehen, daß zunächst auf einem Kopiergerät, insbesondere einem ZnO-Trockenkopierer von einer spiegelverkehrten Vorlage eine spiegelverkehrte Kopie der zu übertragenden Abbildung hergestellt wird. So erhält man schnell und überraschend einfach die erfindungsgemäße Übertragungsfolie.

In Ausgestaltung der Erfindung ist vorgesehen, daß die Kopie auf 80° C bis 140° C, insbesondere jedoch auf 100° C bis 120° C, erwärmt und unter Druckanwendung auf die mit der Abbildung zu versehende Oberfläche aufgelegt wird. Durch die Einwirkung von Druck und Temperatur verbindet sich die adhäsive Deckschicht, d.h. die Tonerschicht, fest mit der Metallschicht auf der Oberfläche der Platine o.ä.. Der Temperaturbereich von 80° C bis 140° C hat sich dabei als günstigster Temperaturbereich für die handelsüblichen Toner herausgestellt, insbesondere geeignet ist der Temperaturbereich von 100° C bis 120° C. Dieser Bereich ist der Bereich, in dem die Toner aller bekannten xerographischen Kopierverfahren, die für das Abziehen des Grundmaterials notwendige hohe Haftfestigkeit aufweisen. Die Übertragung der Abbildung erfolgt durch mittelbares Haften der Überträgerschicht über den Toner auf der Oberfläche. Anschließend an das Aufbringen von Druck und Temperatur mit der als Folge auftretenden festen Verklebung der Tonerchicht mit der Metalloberfläche kann das Grundmaterial der Übertragungsfolie ohne weitere Vorkehrungen abgezogen werden. So erfolgt die Übertragung des Schaltbildes o.ä. leicht und überraschend einfach sowie fehlersicher.

Es ist in Ausgestaltung der Erfindung vorgesehen, daß die Erwärmung elektrisch erfolgt und nach Höhe und Dauer automatisch gesteuert wird. So ist sichergestellt, daß weder der Temperaturbereich der optimalen Haftfestigkeit überschritten wird, noch daß unerwünschte Diffusionsvorgänge, die zu einer Beeinträchtigung des guten Auflösungsvermögens führen könnten, auftreten.

In Ausgestaltung der Erfindung ist vorgesehen, daß der Druck durch Druckluft aufgebracht wird. Die Verwendung von Druckluft ermöglicht eine besonders gute und genaue Dosierung der Druckkraft, die überraschenderweise nur relativ gering zu sein braucht. Eine mechanische Druckerzeugung ist gegenüber der Verwendung von Druckluft schlechter zu kontrollieren und eine hydraulische Druckerzeugung ist zu aufwendig.

Zur Durchführung des Verfahrens ist eine Vorrichtung vorgesehen, die zweiteilig ausgebildet ist und aus einem Kopierer, vorzugsweise einem ZnO-Trockenkopierer und einer beheizbaren Übertragungsvorrichtung besteht. Durch die beiden funktionell miteinander verbundenen Teile der Übertragungsvorrichtung ergibt sich ein technisch funktionell einheitliches Ganzes. Dieses ermöglicht es, in erfindungsgemäßer Weise Platinen mit gedruckten Schaltungen etc. kostengünstig und einfach herzustellen. Die beiden Teile der Vorrichtung sind in der Regel getrennt, sie können aber auch direkt miteinander verbunden sein. Dann ist eine vollautomatische Vervielfältigung und Übertragung möglich. Kostengünstiger ist jedoch die getrennte Anordnung, da so handelsübliche Zinkoxyd -Trockenkopierer verwendet werden können, die neben der Herstellung von Übertragungsfolien auch zur Anfertigung von normalen Kopien dienen.

In Ausgestaltung der Erfindung ist vorgesehen, daß die Übertragungsvorrichtung ein Induktionsheizsystem mit ebener Oberfläche, Eisenkernen und einer Induktionswicklung in den Nuten der Eisenkerne aufweist. Durch die Verwendung eines Induktionsheizsystems wird vorteilhaft die Wärme für das Haften der Überträgerschicht dort erzeugt, wo es für den Haftprozeß am günstigsten ist, nämlich in der Metalldeckschicht der Platine oder im zu ätzenden Körper. Der nichtleitende Teil der Platine wird ebensowenig erwärmt wie das Grundmaterial der Übertragungsfolie. So wird das Abziehen des Grundmaterials von der festhaftenden Übertragungsschicht wesentlich erleichtert.

In Ausgestaltung der Erfindung ist dabei vorgesehen, daß die Übertragungsvorrichtung ein vorzugsweise durch Druckluft beaufschlagbares Andrucksystem in Form einer allseitig druckdicht eingespannten Gummimembran o.ä. aufweist. So ist die Aufbringung der Übertragungsdruckkraft durch Druckluft besonders leicht und einfach. Darüberhinaus ist das Induktionsheizsystem gekapselt und gegen Beschmutzung, Beschädigung etc. vollständig geschützt.

In weiterer Ausgestaltung der Erfindung ist dabei vorgesehen, daß die Übertragungsvorrichtung eine feste Widerlagerplatte zur Klemmung des Körpers mit der mit der Abbildung zu versehenden Oberfläche aufweist und in weiterer Ausbildung mit einer Öffnungsautomatik und/oder einem Arbeitstemperaturanzeigegerät versehen ist. Hierdurch erhält die Übertragungsvorrichtung die vorteilhafte, für eine genaue und schnelle Bedienung erforderliche Ausgestaltung, die insbesondere eine weitgehende Sicherheit gegen Überhitzen aufweist.

Die Erfindung wird anhand von Zeichnungen mit vergrößert dargestellter Übertragungsfolie näher erläutert. Die Zeichnungen zeigen ein besonders bevorzugtes Ausführungsbeispiel, aus dem weitere vorteilhafte Einzelheiten entnehmbar sind.

Die Zeichnungen zeigen im einzelnen:

in Fig. 1     die schematisierte Darstellung einer von einer Endträgeroberfläche wieder abgenommenen Übertragungsfolie sowie

in Fig. 2     eine schematisierte Übertragungsvorrichtung mit eingelegtem Endträger im Schnitt

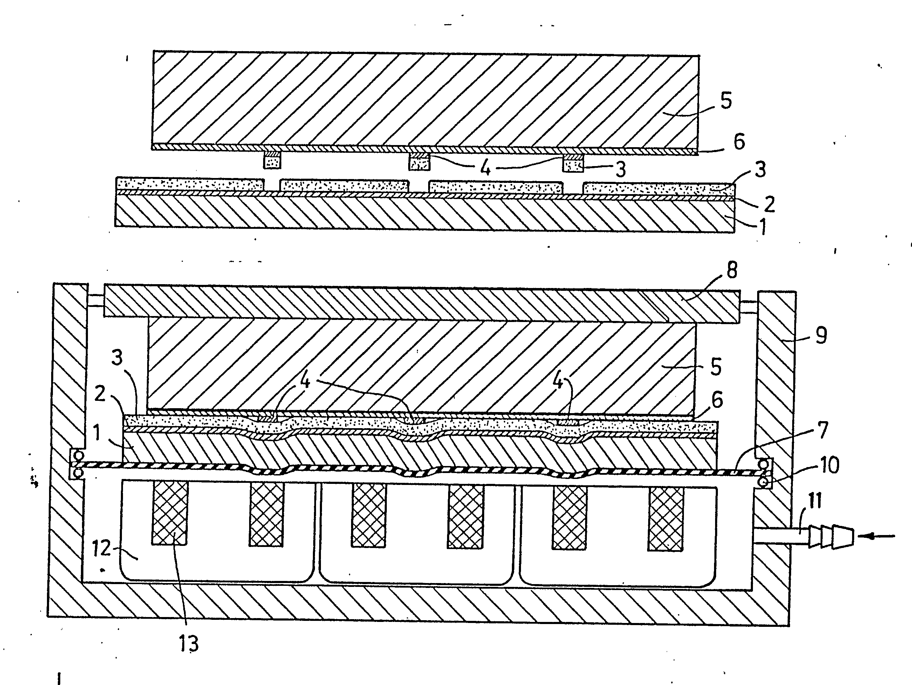

In Fig. 1 und Fig. 2 sind gleiche Teile mit gleichen Bezugsziffern bezeichnet.

In Fig. 1 bezeichnet 1 das Grundmaterial, z.B. das Papierblatt der Übertragungfolie. Auf dem Grundmaterial 1 ist zunächst die Trennschicht 2 aufgebracht, deren Dicke im µ-Bereich liegt. Auf der Trennschicht 2 befindet sich die Metalloxydschicht 3, vorzugsweise eine ZnO-Schicht, so daß die Übertragungsfolie in erfinderischer Weise den Aufbau eines handelsüblichen Trockenkopierpapiers aufweist.

An den Stellen, an denen auf der ZnO-Schicht 3 Tonermaterial 4 durch den Kopiervorgang aufgebracht ist, ist der Toner 4 durch Verklebung unter der Einwirkung von Druck und Temperatur in der Übertragungsvorrichtung 9 so fest mit der Metalloberfläche 6 des Endträgers 5 verbunden, daß die mit Toner 4 bedeckten Teile der ZnO-Schicht 3 sich beim Abziehen des Grundmaterials 1 von den übrigen, nicht mit Toner 4 bedeckten Teilen der ZnO-Schicht 3 getrennt haben. So ergibt sich auf der Oberfläche des Endträgers, z.B. der Platine o.ä. eine ätzfähige Abbildung, die im Maßstab 1 : 1 der im Trockenkopierverfahren erzeugten Abbildung entspricht.

Das Grundmaterial liegt in Fig. 2, die die Übertragungsvorrichtung im Übertragungszeitpunkt zeigt, auf der Gummimembran oder auf einem Luftkissen 7 auf und wird oben von der Widerlagerplatte 8 der Übertragungsvorrichtung 9 gehalten. Die Druckluft zur Erzeugung der Druckkraft tritt durch den Anschlußstutzen 11 ein. Die Gummimembran 7 wird durch Dichtungen 10 gehalten und gleichzeitig abgedichtet.

Im Unterteil der Übertragungsvorrichtung 9 befinden sich Eisenkerne 12, insbesondere in E-Form, mit in die Nuten eingelegten Wicklungen 13, die in der Kupferschicht der Platine oder in einem anderen metallenen Endträger, auf die die Abbildung übertragen werden soll, ein Wirbelfeld erzeugen. Durch das Wirbelfeld entsteht die erfindungsgemäße eng begrenzte Erwärmung des Endträgers zur Haftung der adhäsiven Deckschicht, d.h. des Toners.

Die Übertragungsvorrichtung 9, die vorzugsweise von dem Kopiergerät getrennt aufgestellt wird, kann im Rahmen der Erfindung auch mit dem Kopiergerät fest verbunden sein. In diesem Fall tritt die Übertragungsvorrichtung 9 an Stelle des Aufnahmekastens für die fertig kopierten Kopien. So ergibt sich eine Vorrichtung, die zunächst die gewünschte Abbildung auf die Übertragungsfolie 1 überträgt und anschließend selbsttätig in die Übertragungsvorrichtung 9 einlegt. Diese ist dann vorzugsweise vollautomatisch arbeitend ausgebildet.

Obwohl das Verfahren speziell für die Erzeugung von Leiterplatten mit gedruckter Schaltung entwickelt wurde, können damit vorteilhaft ohne den Rahmen der Erfindung zu verlassen auch beliebige andere Abbildungen auf ätzbare Oberflächen übertragen werden, z.B. alte Münzbilder, Kupferstiche oder Stahlstiche usw..

Das erfindungsgemäße Verfahren kann auch mit anderen als metalloxydbeschichteten Kopierpapieren durchgeführt werden. Die Abbildungsergebnisse mit ZnO-Papier und den xerographischen Verfahren sind jedoch z.Zt. am überzeugensten.

0054310

Anlage zum Patentgesuch                                    Kar/80/1
von H. Karnikowski
4600 Dortmund


            Übertragungsfolie für die Übertragung von
            Abbildungen auf Oberflächen, sowie Über-
            tragungsverfahren und Vorrichtung.


            Patentansprüche .


1. Übertragungsfolie, vorzugsweise mit dem Grundmaterial
   Papier, für die Übertragung von Abbildungen auf
   Oberflächen, insbesondere auf die Cu-Deckschicht von
   Platinen oder auf andere ätzbare Oberflächen, d a -
   d u r c h   g e k e n n z e i c h n e t, daß sie eine
   die Abbildung in spiegelverkehrter Form aufweisende,
   lösbare Überträgerschicht (3), insbesondere eine
   Metalloxydschicht mit einer adhäsiven Dickschicht (4),
   auf der Oberfläche aufweist.


2. Folie nach Anspruch 1, d a d u r c h   g e k e n n -
   z e i c h n e t, daß zwischen der Überträgerschicht
   (3), z.B. der Metalloxydschicht und dem Grundmaterial
   (1) der Folie eine, vorzugsweise thermoplastische,
   Trennschicht (2) angeordnet ist.

3. Folie nach Anspruch 1 oder 2, d a d u r c h   g e -
k e n n z e i c h n e t, daß das Metalloxyd elektrisch
aufladbar und durch Lichteinwirkung entladbar,
insbesondere ZnO ist.

4. Folie nach Anspruch 1, 2 oder 3, d a d u r c h   g e -
k e n n z e i c h n e t, daß die adhäsive Deckschicht
(4) thermoplastisch, vorzugsweise mit höherem
Erweichungspunkt als die Trennschicht (2) ist.

5. Folie nach Anspruch 1, 2, 3 oder 4, d a d u r c h
g e k e n n z e i c h n e t, daß die Metalloxydschicht
die ZnO-Schicht eines Kopierpapiers und die adhäsive
Deckschicht der Toner auf dem kopierten Kopierpapier
ist.

6. Übertragungsverfahren für die Übertragung von
Abbildungen auf Oberflächen, insbesondere auf
Platinen, vorzugsweise unter Verwendung einer Folie
nach einem der Ansprüche 1 bis 5, d a d u r c h   g e -
k e n n z e i c h n e t, daß zunächst auf einem
Kopiergerät, insbesondere einem ZnO Trockenkopierer,
von einer spiegelverkehrten Vorlage eine spiegelverkehrte Kopie der zu übertragenden Abbildung hergestellt wird.

7. Verfahren nach Anspruch 6, d a d u r c h   g e k e n n -
z e i c h n e t, daß die Kopie auf 80° C bis 140° C,
insbesondere jedoch auf 100° C bis 120° C erwärmt und
unter Druckanwendung auf die mit der Abbildung zu
versehende Oberfläche aufgelegt wird.

8. Verfahren nach Anspruch 6 oder 7, d a d u r c h   g e -
k e n n z e i c h n e t, daß die Übertragung der
Abbildung durch mittelbares Haften der Überträgerschicht über den Toner auf der Oberfläche erfolgt.

9. Verfahren nach Anspruch 7 oder 8, d a d u r c h  g e - k e n n z e i c h n e t, daß die Erwärmung elektrisch erfolgt.

10. Verfahren nach Anspruch 7, 8 oder 9, d a d u r c h  g e k e n n z e i c h n e t, daß die Erwärmung nach Höhe und/oder Dauer automatisch gesteuert erfolgt.

11. Verfahren nach Anspruch 7, 8, 9 oder 10, d a - d u r c h  g e k e n n z e i c h n e t, daß der Druck durch Druckluft aufgebracht wird.

12. Vorrichtung für die Durchführung des Verfahrens nach einem der Ansprüche 6 bis 11, d a d u r c h  g e - k e n n z e i c h n e t, daß sie zweiteilig ausgebildet ist und aus einem Kopierer, vorzugsweise einem ZnO-Trockenkopierer und einer beheizbaren Übertragungsvorrichtung (9) besteht.

13. Übertragungsvorrichtung nach Anspruch 12, d a - d u r c h  g e k e n n z e i c h n e t, daß sie ein Induktionsheizsystem mit ebener Oberfläche, Eisenkernen (12) und einer Induktionswicklung (13) in Nuten der Eisenkerne (12) aufweist.

14. Übertragungsvorrichtung nach Anspruch 12 oder 13, d a d u r c h  g e k e n n z e i c h n e t, daß sie ein, vorzugsweise durch Druckluft beaufschlagbares Andrucksystem aufweist.

15. Übertragungsvorrichtung nach Anspruch 14, d a - d u r c h  g e k e n n z e i c h n e t, daß die Andruckvorrichtung ein allseitig eingespanntes Luftkissen, eine Gummimembran (7) o.ä. ist.

16. Übertragungsvorrichtung nach Anspruch 12, 13, 14 oder 15, d a d u r c h g e k e n n z e i c h n e t, daß sie eine feste Widerlagerplatte (8) zur Klemmung des Körpers (5) mit der mit der Abbildung zu versehenden Oberfläche aufweist.

17. Vorrichtung nach Anspruch 16, d a d u r c h g e - k e n n z e i c h n e t, daß die Widerlagerplatte (8) eine Öffnungsautomatik und/oder ein Arbeitstemperatur- anzeigegerät aufweist.

– Beschreibung –